# EUROPÄISCHE PATENTSCHRIFT

(11) **EP 3 737 637 B1**
(45) Veröffentlichungstag und Bekanntmachung des Hinweises auf die Patenterteilung: **23.11.2022**
(21) Anmeldenummer: 18811812.9
(22) Anmeldetag: 30.11.2018
(51) Int. Cl.: B81B 7/00, B81B 3/00, G02B 26/08

(54) **MEMS-VORRICHTUNG MIT INTERPOSERSUBSTRAT SOWIE ENTSPRECHENDES HERSTELLUNGSVERFAHREN**
MEMS DEVICE COMPRISING INTERPOSER SUBSTRATE AND CORRESPONDING MANUFACTURING METHOD
DISPOSITIF MEMS COMPORTANT SUBSTRAT INTERCALAIRE ET PROCÉDÉ DE FABRICATION CORRESPONDANT

(30) Priorität: 11.01.2018 DE 102018200371
(43) Veröffentlichungstag der Anmeldung: 18.11.2020
(73) Patentinhaber: Robert Bosch GmbH, 70442 Stuttgart (DE)
(72) Erfinder: MUCHOW, Joerg, 81477 Muenchen (DE); STRAUB, Rainer, 72119 Ammerbuch (DE); MARK, Stefan, 97074 Wuerzburg (DE); KOEPERNIK, Corinna, 72764 Reutlingen (DE)
(86) Internationale Anmeldenummer: PCT/EP2018/083150
(87) Internationale Veröffentlichungsnummer: WO 2019/137693

(56) Entgegenhaltungen:
- WO-A1-2008/087022
- DE-A1-102004 050 051
- US-A1- 2004 028 566
- US-A1- 2011 236 277
- US-A1- 2014 084 394
- US-B1- 8 921 957

## Beschreibung

Die vorliegende Erfindung betrifft eine MEMS-Vorrichtung sowie ein entsprechendes Herstellungsverfahren.

### Stand der Technik

Obwohl auf beliebige mikromechanische Vorrichtungen und Systeme anwendbar, werden die vorliegende Erfindung und die ihr zugrundeliegende Problematik anhand von Mikrospiegelvorrichtungen erläutert.

Mikrospiegelvorrichtungen mit entsprechenden Antrieben sind beispielsweise aus der DE 10 2012 219 591 A1, der DE 10 2010 062 118 A1 und der WO 2013/091939 A1 bekannt.

Die WO 2004/017371 A2 beschreibt ein Interposersubstrat für eine MEMS-Vorrichtung sowie ein entsprechendes Herstellungsverfahren.

Die bekannten Mikrospiegelvorrichtungen besitzen einen auf der Rückseite (die vom Mikrospiegel abgekehrte Seite) befindlichen Kappenwafer, der den Antriebsaktor mechanisch und hermetisch verkappt. Dieser Kappenwafer besitzt Kavernen, um die Bewegungsfreiheit des Mikrospiegels zu gewährleisten, sowie Anschläge, die für eine Robustheit des Antriebsaktors sorgen.

Die Kavernen für die Bewegungsfreiheit und die Anschläge derartiger elektromagnetischer Antriebsaktoren bzw. PZT-Antriebsaktoren werden üblicherweise durch einen DRIE-Ätzprozess hergestellt (Deep Reactive Ion Etching). Dieser zeitgesteuerte Ätzprozess ist mit Fertigungstoleranzen von typischerweise +/- 15 % behaftet. Für Spiegel mit großem Scanfeld resultiert das in großen Ätztiefen beispielsweise von 500 µm.

Zudem sind bei Mikrospiegelvorrichtungen hermetische Gehäuse und geneigte Fenster zur Vermeidung des direkten Reflexes im Bild gefordert. Dies ist eine fertigungstechnische Herausforderung, und spezielle Fertigungsschritte, wie z.B.

Kavernen für die Bewegungsfreiheit und Anschläge, in Wafer oder schräge Fenster gefährden die Hermetizität und Defektfreiheit der Glasoberfläche.

Weitere Interposersubstrate für eine MEMS-Vorrichtung, sowie entsprechende Herstellungsverfahren werden in den Dokumenten US 2004/028566 A1, US 2011/236277 A1, US 8 921 957 B1, WO 2008/087022 A1 und DE 10 2004 050051 A1 beschrieben. US 8 921 957 B1 offenbart eine MEMS-Vorrichtung mit einem Interposersubstrat. Das Interposersubstrat weist auf: eine von der Rückseite ausgehenden Kaverne, welche sich bis zu einer ersten Tiefe erstreckt, eine Durchgangsöffnung und einen zwischen der Kaverne und der Durchgangsöffnung angeordneten Absenkungsbereich, welcher ausgehend von der Rückseite bis zu einer zweiten Tiefe gegenüber der Rückseite abgesenkt ist, wobei die erste Tiefe größer als die zweite Tiefe ist. Die MEMS-Vorrichtung weist eine erste bewegliche Struktur in Form einer Membran auf. Dieses Dokument lehrt auch ein Herstellungsverfahren für ein Interposersubstrat mit den Schritten: Bereitstellen eines unstrukturierten Interposersubstrats mit einer Vorderseite und einer Rückseite, Bilden einer von der Rückseite ausgehenden ersten Kaverne, welche sich bis zu einer ersten Tiefe erstreckt, Bilden einer von der Rückseite ausgehenden zweiten Kaverne, welche sich bis zu der ersten Tiefe erstreckt, Bilden eines zwischen der ersten Kaverne und der zweiten Kaverne angeordneten Absenkungsbereichs, welcher ausgehend von der Rückseite bis zu einer zweiten Tiefe gegenüber der Rückseite abgesenkt ist, wobei die erste Tiefe größer als die zweite Tiefe ist.

### Offenbarung der Erfindung

Die Erfindung schafft eine MEMS-Vorrichtung nach Anspruch 1, sowie ein Herstellungsverfahren für ein Interposersubstrat nach Anspruch 6.

Bevorzugte Weiterbildungen sind Gegenstand der jeweiligen Unteransprüche.

### Vorteile der Erfindung

Die der vorliegenden Erfindung zugrunde liegende Idee sieht ein Interposersubstrat vor, welches zumindest eine rückseitige Kaverne für die Bewegungsfreiheit und zumindest einen rückseitigen Absenkungsbereich für einen Anschlag eines Aktors vorsieht.

Weiterhin ist in einem einfachen Prozessschritt das Bilden einer Durchgangsöffnung möglich, welche als Zugangsöffnung für die MEMS-Vorrichtung dient.

Alle diese Funktionen lassen sich erfindungsgemäß in einem einzigen Interposersubstrat realisieren. Das Herstellungsverfahren des Interposersubstrats kann die Waferdicke mit einer geringen Toleranz von einigen Mikrometern für die Bewegungsfreiheit ausnutzen und reduziert damit die Ätzzeit und folglich die Kosten des Herstellungsprozesses.

Die durch den oder die Absenkungsbereiche definierten Anschlagsebenen lassen sich mit beliebiger Tiefe und in beliebiger Designfreiheit herstellen. Die Durchgangsöffnung kann ebenfalls Raum für die Bewegungsfreiheit mechanischer Strukturen bilden. Um Anschlagstiefen von beispielsweise 20 µm zu realisieren, ist die Ätzung dieser 20 µm der einzige notwendige Produktionsschritt. Dadurch können sehr geringe Toleranzen erzielt werden. Es gibt zwei glatte Oberflächen, die Vorderseite und die Rückseite des Interposersubstrats, die den ursprünglichen Oberflächen des Substratmaterials, beispielsweise des Siliziummaterials, entsprechen. Dies ist eine wichtige Voraussetzung für eine hermetische Verbindung zwischen dem Interposersubstrat und weiteren Komponenten der MEMS-Vorrichtung, beispielsweise einem optischen Sockel und einem Mikrospiegel. Die Herstellung ist im Wafer-Verbund möglich.

Gemäß einer bevorzugten Weiterbildung bildet der Absenkungsbereich einen durchgehenden Übergangsbereich zwischen der Kaverne und der Durchgangsöffnung. Dies vergrößert den zur Verfügung stehenden Freiraum.

Gemäß einer weiteren bevorzugten Weiterbildung sind mehrere Kavernen vorgesehen, welche sich bis zu der ersten Tiefe erstrecken. So lassen sich mehrere bewegliche Strukturen beherbergen.

Gemäß einer weiteren bevorzugten Weiterbildung sind zwischen der Kaverne und der Durchgangsöffnung mehrere Absenkungsbereiche angeordnet, welche ausgehend von der Rückseite bis zu der zweiten Tiefe gegenüber der Rückseite abgesenkt sind. Dies ermöglicht eine genaue Anpassung an die jeweilige bewegliche Struktur.

Gemäß einer weiteren bevorzugten Weiterbildung weist das MEMS-Substrat eine bewegliche Mikrospiegeleinrichtung auf, welche in die Durchgangsöffnung hinein beweglich ist, und wobei die Durchgangsöffnung als Lichtauslassbereich der Mikrospiegeleinrichtung dient. Vorzugsweise umfassen die erste bewegliche Struktur und die zweite bewegliche Struktur Antriebselemente für die Mikrospiegeleinrichtung, wobei auf das Interposersubstrat eine optische Fenstereinrichtung gebondet ist. So lässt sich der Raumbedarf für die Mikrospiegeleinrichtung gering halten.

Gemäß einer weiteren bevorzugten Weiterbildung ist in das Interposersubstrat eine optische Erfassungseinrichtung zum Erfassen mindestens einer Bewegungsgröße, insbesondere einer Auslenkung, der Mikrospiegeleinrichtung integriert. Dies ermöglicht die Bereitstellung von Informationen über die Antriebsbewegung, welche nützlich für eine Regelvorrichtung sind.

### Kurze Beschreibung der Zeichnungen

Weitere Merkmale und Vorteile der vorliegenden Erfindung werden nachfolgend anhand von Ausführungsformen mit Bezug auf die Figuren erläutert.

Es zeigen:
- Fig. 1a)-i): schematische Querschnittsdarstellungen zum Erläutern der Prozessstadien eines Herstellungsverfahrens für ein Interposersubstrat gemäß einer ersten Ausführungsform der vorliegenden Erfindung;
- Fig. 2: eine schematische Querschnittsdarstellung einer MEMS-Vorrichtung mit einem Interposersubstrat gemäß einer zweiten Ausführungsform der vorliegenden Erfindung; und
- Fig. 3: eine schematische Querschnittsdarstellung einer MEMS-Vorrichtung mit einem Interposersubstrat gemäß einer dritten Ausführungsform der vorliegenden Erfindung.

### Ausführungsformen der Erfindung

In den Figuren bezeichnen gleiche Bezugszeichen gleiche bzw. funktionsgleiche Elemente.

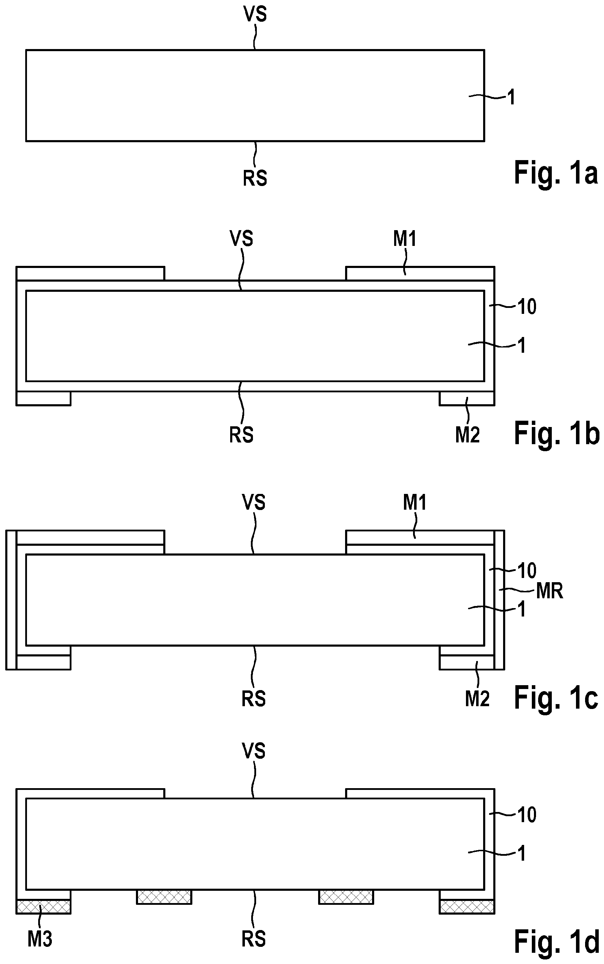

Fig. 1a)-i) sind schematische Querschnittsdarstellungen zum Erläutern der Prozessstadien eines Herstellungsverfahrens für ein Interposersubstrat gemäß einer ersten Ausführungsform der vorliegenden Erfindung.

Ausgangspunkt gemäß Fig. 1a) für das Herstellungsverfahren gemäß der ersten Ausführungsform ist ein unstrukturiertes Interposersubstrat 1 mit einer Vorderseite VS und einer Rückseite RS. Beispielsweise kann als Interposersubstrat ein üblicher Si-Rohwafer verwendet werden. Die Kristallrichtung kann je nach Anwendung gewählt werden, beispielsweise die 110-Richtung, wobei bei dieser 110-Richtung während des anisotropen Ätzvorgangs quadratische Löcher in 110-Richtung erzeugt werden.

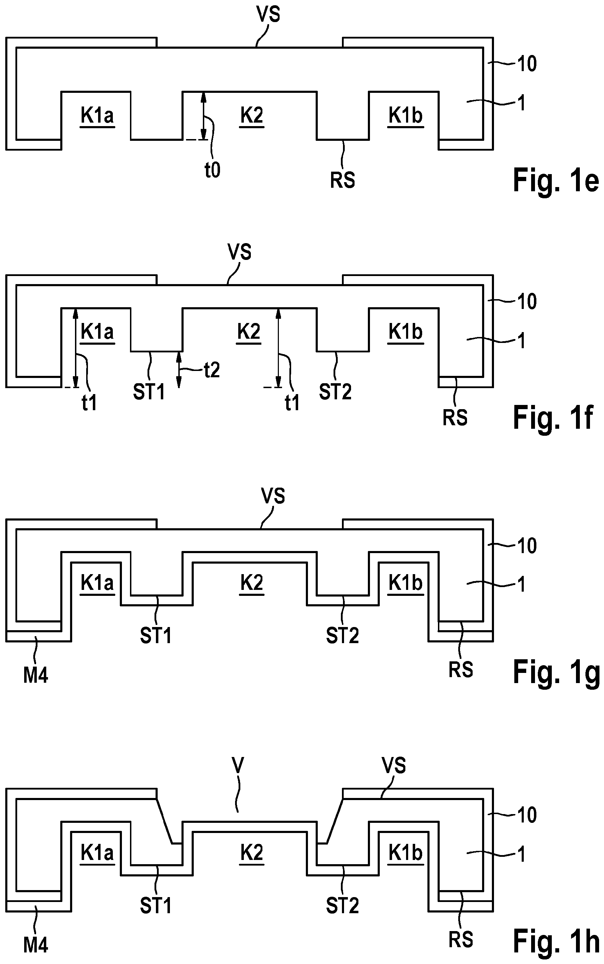

Weiter mit Bezug auf Fig. 1b) erfolgt ein allseitiges Aufbringen einer ersten Schutzschicht 10, z.B. durch thermisches Oxidieren oder durch Abscheidung von SiN. Danach erfolgt ein Aufbringen einer ersten Maske M1 auf die Vorderseite VS, welche die später herzustellende Durchgangsöffnung V definiert (vgl. Fig. 1h)).

In einem anschließenden Prozessschritt erfolgt ein Aufbringen einer zweiten Maske M2 auf die Rückseite RS, welche den Bereich der später herzustellenden Kavernen (vgl. Fig. 1e)) definiert.

Zusätzlich wird nach dem Aufbringen der ersten Maske M1 und der zweiten Maske M2, beispielsweise durch übliche Lithografie, eine Randbelackung mit einer Randlackschicht MR, um den Waferrand bei den späteren Strukturierungsschritten zu schützen. Danach wird, wie in Fig. 1c) gezeigt, die erste Schutzschicht 10 auf der Vorderseite VS und der Rückseite RS dort entfernt, wo die erste bzw. zweite Maske M1, M2 geöffnet ist.

Im Anschluss daran werden gemäß Fig. 1d) die erste Maske M1 und die zweite Maske M2 sowie die Randbelackung MR entfernt, und es wird eine dritte Maske M3 auf der Rückseite RS vorgesehen, welche zur darauffolgenden Strukturierung der zu bildenden Kavernen dient.

Weiter mit Bezug auf Fig. 1e) werden durch einen DRIE-Ätzprozess erste Kavernen K1a, K1b und eine zweite Kaverne K2 ausgehend von der Rückseite RS bis zu einer Zwischentiefe t0 gebildet. Die dritte Maske M3 schützt dabei die später zu bildenden Absenkungsbereiche ST1, ST2. Im Anschluss an diesen ersten DRIE-Ätzschritt wird nach Erreichen der Zwischentiefe t0 die dritte Maske M3 von der Rückseite RS entfernt.

Im Prozessschritt gemäß Fig. 1f) erfolgt ein zweiter DRIE-Ätzschritt, wobei die ersten Kavernen K1a, K1b und die zweite Kaverne K2 ausgehend von der Rückseite RS gleichzeitig bis zu einer ersten Tiefe t1 gebildet werden, und wobei dabei gleichzeitig die Absenkungsbereiche ST1, ST2 gebildet werden, welche bis zu einer zweiten Tiefe t2 gegenüber der Rückseite RS abgesenkt sind, wobei die erste Tiefe t1 größer als die zweite Tiefe t2 ist.

Anschließend wird gemäß Fig. 1g) eine zweite Schutzschicht M4 auf der Rückseite RS mit den ersten Kavernen K1a, K1b und der zweiten Kaverne K2 abgeschieden, beispielsweise eine mittels PECVD abgeschiedene Siliziumnitridschicht (SiN).

Danach erfolgt eine vorderseitige Nassätzung mittels KOH zum Bilden einer Durchgangsöffnung V ausgehend von der Vorderseite VS, wobei die KOH-Ätzung auf der Schutzschicht M4 stoppt, wie in Fig. 1h) dargestellt.

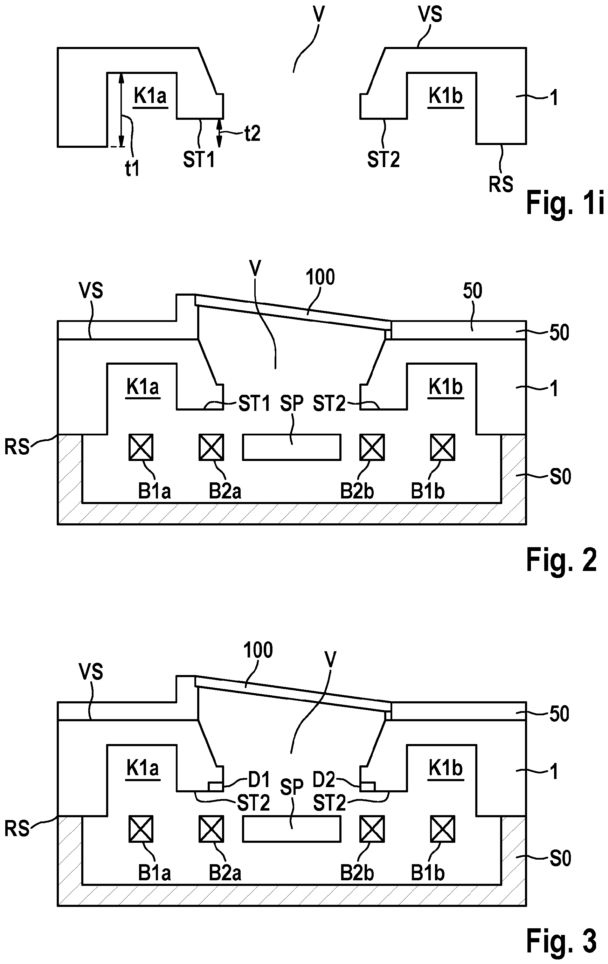

Schließlich mit Bezug auf Fig. 1i) wird die Schutzschicht M4 von der Rückseite RS sowie die Schutzschicht 10 vom restlichen Teil des Interposersubstrats 1 entfernt, was zur endgültigen Struktur des Interposersubstrats 1 führt. Nach Entfernen der Schutzschicht M4 existiert die zweite Kaverne K2 nicht mehr.

Mittels des beschriebenen Herstellungsverfahrens ist es möglich, die Absenkungsbereiche ST1, ST2 und die ersten Kavernen K1a, K1b mit beliebigem Design zu strukturieren, wobei das gewählte Design von der Struktur der später darunter befindlichen MEMS-Vorrichtung abhängt.

Die Kombination der beiden DRIE-Ätzschritte mit dazwischenliegender Entfernung der dritten Maske M3 ermöglicht, dass die ersten Kavernen K1a, K1b in die erste Tiefe t1 abgesenkt werden, welche größer ist als die zweite Tiefe t2 der Absenkungsbereiche ST1, ST2.

Fig. 2 ist eine schematische Querschnittsdarstellung einer MEMS-Vorrichtung mit einem Interposersubstrat gemäß einer zweiten Ausführungsform der vorliegenden Erfindung.

Wie in Fig. 2 dargestellt, ist das Interposersubstrat 1 gemäß Fig. 1i) mit seiner Rückseite RS auf ein MEMS-Substrat S0 gebondet, welches eine erste bewegliche Struktur B1a, B1b und eine zweite bewegliche Struktur B2a, B2b sowie eine Mikrospiegeleinrichtung SP aufweist. Die erste bewegliche Struktur B1a, B1b und die zweite bewegliche Struktur B2a, B2b umfassen einen Antrieb und eine Aufhängung der Mikrospiegeleinrichtung SP und werden im Betrieb aus der Bondebene des MEMS-Substrats S0 heraus in Richtung des Interposersubstrats 1 ausgelenkt.

Dabei ist die Orientierung derart, dass die erste bewegliche Struktur B1a, B1b in die ersten Kavernen K1a, K1b hinein beweglich ist und dass die Absenkungsbereiche ST1, ST2 als Anschlagbereiche für die zweite bewegliche Struktur B2a, B2b dienen.

Die Mikrospiegeleinrichtung SP ist durch Verkippen in die Durchgangsöffnung V hinein beweglich, wobei die Durchgangsöffnung V als Lichtauslassbereich für die Mikrospiegeleinrichtung SP dient.

Auf das Interposersubstrat 1 ist eine optische Fenstereinrichtung 50, 100 gebondet, welche einen Fensterrahmen 50 und ein Fensterglas 100 aufweist.

Da bei der vorliegenden zweiten Ausführungsform die Mikrospiegeleinrichtung in die Durchgangsöffnung V hinein und die erste bewegliche Struktur B1a, B1b in die ersten Kavernen K1a, K1b hinein beweglich ist und die Absenkungsbereiche ST1, ST2 als Anschlagbereiche für die zweite bewegliche Struktur B2a, B2b dienen, ist die Anordnung hinsichtlich ihrer Dicke raumsparender im Vergleich zu bekannten Kappenstrukturen.

Fig. 3 ist eine schematische Querschnittsdarstellung einer MEMS-Vorrichtung mit einem Interposersubstrat gemäß einer dritten Ausführungsform der vorliegenden Erfindung.

Bei der dritten Ausführungsform sind im Interposersubstrat zusätzlich optische Erfassungseinrichtungen D1, D2 im Bereich der Durchgangsöffnung V innerhalb der Anschlagsbereiche ST1, ST2 integriert, welche beispielsweise Fotodioden aufweisen. Die Herstellung kann beispielsweise nach dem zweiten DRIE-Ätzschritt erfolgen. Auch ist es möglich, die optischen Erfassungseinrichtungen D1, D2 in nicht abgesenkten Bereichen der Rückseite RS vorzusehen, wobei die entsprechende Prozessierung vor den übrigen Strukturierungsschritten stattfinden könnte. Die Herstellung der Dioden D1, D2 vor der Strukturierung auf einer planaren Oberfläche erleichtert den Prozessverlauf, da später keine entsprechenden Schutzschichten vorgesehen werden müssen.

Die optischen Erfassungseinrichtungen D1, D2 dienen zum Erfassen mindestens einer Bewegungsgröße, insbesondere einer Auslenkung, der Mikrospiegeleinrichtung SP im Betrieb. Derartige Informationen über den aktuellen Strahlverlauf geben die Möglichkeit, ein wertvolles Eingangssignal für einen Regelkreis zu liefern. Insbesondere ist die Maximalauslenkung der Mikrospiegeleinrichtung SP von Interesse für die Regelung des Scanbereichs.

Obwohl die vorliegende Erfindung anhand bevorzugter Ausführungsbeispiele beschrieben wurde, ist sie darauf nicht beschränkt. Insbesondere sind die genannten Materialien und Topologien nur beispielhaft und nicht auf die erläuterten Beispiele beschränkt.

Obwohl die voranstehenden Ausführungsformen anhand von MEMS-Vorrichtungen mit Mikrospiegeleinrichtungen erläutert worden sind, kann das Interposersubstrat natürlich auch für andere mikromechanische Aktoren und Sensoren verwendet werden, bei denen bewegliche Strukturen aus der MEMS-Substratebene heraus gekippt werden, wie z.B. eine z-Wippe für Beschleunigungssensoren, oder Beschleunigungs- bzw. Drehratensensoren mit einem oder mehreren rotatorischen Freiheitsgraden.

## Patentansprüche

1. MEMS-Vorrichtung mit einem Interposersubstrat (1), wobei das Interposersubstrat (1) aufweist:
eine Vorderseite (VS) und eine Rückseite (RS);
eine von der Rückseite (RS) ausgehenden Kaverne (K1a; K1b), welche sich bis zu einer ersten Tiefe (t1) erstreckt;
eine Durchgangsöffnung (V); und
einen zwischen der Kaverne (K1a; K1b) und der Durchgangsöffnung (V) angeordneten Absenkungsbereich (ST1; ST2), welcher ausgehend von der Rückseite (RS) bis zu einer zweiten Tiefe (t2) gegenüber der Rückseite (RS) abgesenkt ist;
wobei die erste Tiefe (t1) größer als die zweite Tiefe (t2) ist,
wobei die MEMS-Vorrichtung zusätzlich aufweist:
ein MEMS-Substrat (S0), welches eine erste bewegliche Struktur (B1a; B1b) und eine zweite bewegliche Struktur (B2a; B2b) aufweist;
wobei das Interposersubstrat (1) derart auf das MEMS-Substrat (S0) gebondet ist, dass die erste bewegliche Struktur (B1a, B1b) in die Kaverne (K1a; K1b) hinein beweglich ist und dass der Absenkungsbereich (ST1; ST2) als Anschlagbereich für die zweite bewegliche Struktur (B2a; B2b) dient.

2. MEMS-Vorrichtung nach Anspruch 1, wobei das MEMS-Substrat (S0) eine bewegliche Mikrospiegeleinrichtung (SP) aufweist, welche in die Durchgangsöffnung (V) hinein beweglich ist, und wobei die Durchgangsöffnung (V) als Lichtauslassbereich die die Mikrospiegeleinrichtung (SP) dient.

3. MEMS-Vorrichtung nach Anspruch 2, wobei die erste bewegliche Struktur (B1a; B1b) und die zweite bewegliche Struktur (B2a; B2b) Antriebselemente für die Mikrospiegeleinrichtung (SP) umfassen.

4. MEMS-Vorrichtung nach Anspruch 2 oder 3, wobei auf das Interposersubstrat (1) eine optische Fenstereinrichtung (50, 100) gebondet ist.

5. MEMS-Vorrichtung nach Anspruch 2, 3 oder 4, wobei in das Interposersubstrat (1) eine optische Erfassungseinrichtung (D1; D2) zum Erfassen mindestens einer Bewegungsgröße, insbesondere einer Auslenkung, der Mikrospiegeleinrichtung (SP) integriert ist.

6. Herstellungsverfahren für ein Interposersubstrat (1) mit den Schritten:
Bereitstellen eines unstrukturierten Interposersubstrats (1) mit einer Vorderseite (VS) und einer Rückseite (RS);
Bilden einer von der Rückseite (RS) ausgehenden ersten Kaverne (K1a; K1b), welche sich bis zu einer ersten Tiefe (t1) erstreckt;
Bilden einer von der Rückseite (RS) ausgehenden zweiten Kaverne (K2), welche sich bis zu der ersten Tiefe (t1) erstreckt;
Bilden eines zwischen der ersten Kaverne (K1a; K1b) und der zweiten Kaverne (K2) angeordneten Absenkungsbereichs (ST1; ST2), welcher ausgehend von der Rückseite (RS) bis zu einer zweiten Tiefe (t2) gegenüber der Rückseite (RS) abgesenkt ist;
wobei die erste Tiefe (t1) größer als die zweite Tiefe (t2) ist;
Bilden einer Durchgangsöffnung (V) ausgehend von der Vorderseite (VS) durch Entfernen eines oberhalb der zweiten Kaverne (K2) befindlichen Bereichs des Interposersubstrats (1).

7. Herstellungsverfahren nach Anspruch 6, wobei die erste Kaverne (K1a; K1b) und die zweite Kaverne (K2) in einem ersten Ätzschritt ausgehend von der Rückseite (RS) gleichzeitig bis zu einer Zwischentiefe (t0) gebildet werden und dabei der dem später zu bildenden Absenkungsbereich (ST1; ST2) entsprechende Bereich der Rückseite (RS) maskiert ist, und wobei die erste Kaverne (K1a; K1b) und die zweite Kaverne (K2) in einem zweiten Ätzschritt ausgehend von der Rückseite (RS) gleichzeitig bis zu ersten Tiefe (t1) gebildet werden und dabei gleichzeitig der Absenkungsbereich (ST1; ST2) gebildet wird.

8. Herstellungsverfahren nach Anspruch 6 oder 7, wobei nach Bilden der ersten Kaverne (K1a; K1b) und der zweite Kaverne (K2) und des Absenkungsbereichs (ST1; ST2) eine Schutzschicht (M4) auf der Rückseite (RS) abgeschieden wird, bevor die Durchgangsöffnung (V) gebildet wird.

## Claims

1. MEMS device having an interposer substrate (1), wherein the interposer substrate (1) has:
a front side (VS) and a rear side (RS);
a cavity (K1a; K1b), which proceeds from the rear side (RS) and extends to a first depth (t1);
a through-opening (V); and
a depression region (ST1; ST2), which is arranged between the cavity (K1a; K1b) and the through-passage (V) and, proceeding from the rear side (RS), is depressed to a second depth (t2) in relation to the rear side (RS);
wherein the first depth (t1) is greater than the second depth (t2),
wherein the MEMs device additionally has:
a MEMS substrate (S0), which has a first movable structure (B1a; B1b) and a second movable structure (B2a; B2b);
wherein the interposer substrate (1) is bonded to the MEMS substrate (S0) in such a way that the first movable structure (B1a; B1b) is movable into the cavity (K1a; K1b), and in that the depression region (ST1; ST2) serves as a stop region for the second movable structure (B2a; B2b) .

2. MEMS device according to Claim 1, wherein the MEMs substrate (S0) has a movable micromirror unit (SP), which is movable into the through-opening (V), and wherein the through-opening (V) serves as a light outlet region the the micromirror unit (SP).

3. MEMS device according to Claim 2, wherein the first movable structure (B1a; B1b) and the second movable structure (B2a; B2b) comprise drive elements for the micromirror unit (SP).

4. MEMS device according to Claim 2 or 3, wherein an optical window unit (50, 100) is bonded to the interposer substrate (1).

5. MEMS device according to Claim 2, 3 or 4, wherein an optical detection unit (D1; D2) for detecting at least one movement variable, in particular a deflection, of the micromirror unit (SP) is integrated into the interposer substrate (1).

6. Production method for an interposer substrate (1), comprising the steps of:
providing an unstructured interposer substrate (1) having a front side (VS) and a rear side (RS);
forming a first cavity (K1a; K1b), which proceeds from the rear side (RS) and extends to a first depth (t1);
forming a second cavity (K2), which proceeds from the rear side (RS) and extends to the first depth (t1);
forming a depression region (ST1; ST2), which is arranged between the first cavity (K1a; K1b) and the second cavity (K2) and, proceeding from the rear side (RS), is depressed to a second depth (t2) in relation to the rear side (RS);
wherein the first depth (t1) is greater than the second depth (t2);
forming a through-opening (V) proceeding from the front side (VS) by removing a region of the interposer substrate (1) that is situated above the second cavity (K2) .

7. Production method according to Claim 6, wherein, in a first etching step, the first cavity (K1a; K1b) and the second cavity (K2) are simultaneously formed, proceeding from the rear side (RS), to an intermediate depth (t0), and in this case that region of the rear side (RS) which corresponds to the depression region (ST1; ST2) which is to be formed later is masked, and wherein, in a second etching step, the first cavity (K1a; K1b) and the second cavity (K2) are simultaneously formed, proceeding from the rear side (RS), to a first depth (t1), and in this case the depression region (ST1; ST2) is simultaneously formed.

8. Production method according to Claim 6 or 7, wherein, after the first cavity (K1a; K1b) and the second cavity (K2) and the depression region (ST1; ST2) have been formed, a protective layer (M4) is deposited on the rear side (RS) before the through-opening (V) is formed.

## Revendications

1. Dispositif MEMS comprenant un substrat d'interposition (1), dans lequel le substrat d'interposition (1) présente :
un côté avant (VS) et un côté arrière (RS) ;
une cavité (K1a ; K1b) partant du côté arrière (RS) et s'étendant jusqu'à une première profondeur (t1) ;
une ouverture de passage (V) ; et
une zone d'abaissement (ST1 ; ST2) agencée entre la cavité (K1a ; K1b) et l'ouverture de passage (V), qui est abaissée en partant du côté arrière (RS) jusqu'à une deuxième profondeur (t2) par rapport au côté arrière (RS) ;
dans lequel la première profondeur (t1) est supérieure à la deuxième profondeur (t2),
dans lequel le dispositif MEMS présente en outre :
un substrat MEMS (S0), qui présente une première structure mobile (B1a ; B1b) et une deuxième structure mobile (B2a ; B2b) ;
dans lequel le substrat d'interposition (1) est relié sur le substrat MEMS (S0) de telle sorte que la première structure mobile (B1a, B1b) est mobile dans la cavité (K1a ; K1b) et que la zone d'abaissement (ST1 ; ST2) sert de zone de butée pour la deuxième structure mobile (B2a ; B2b) .

2. Dispositif MEMS selon la revendication 1, dans lequel le substrat MEMS (S0) présente un appareil à micromiroir mobile (SP) qui est mobile dans l'ouverture de passage (V), et dans lequel l'ouverture de passage (V) sert de zone de sortie de lumière le l'appareil à micromiroir (SP).

3. Dispositif MEMS selon la revendication 2, dans lequel la première structure mobile (B1a ; B1b) et la deuxième structure mobile (B2a ; B2b) comprennent des éléments d'entraînement pour l'appareil à micromiroir (SP) .

4. Dispositif MEMS selon la revendication 2 ou 3, dans lequel un appareil à fenêtre optique (50, 100) est relié sur le substrat d'interposition (1).

5. Dispositif MEMS selon la revendication 2, 3 ou 4, dans lequel un appareil de détection optique (D1 ; D2) est intégré dans le substrat d'interposition (1) pour détecter au moins une grandeur de mouvement, notamment une déviation, de l'appareil à micromiroir (SP).

6. Procédé de fabrication pour un substrat d'interposition (1), comprenant les étapes suivantes :
la fourniture d'un substrat d'interposition non structuré (1) avec un côté avant (VS) et un côté arrière (RS) ;
la formation d'une première cavité (K1a ; K1b) partant du côté arrière (RS) et s'étendant jusqu'à une première profondeur (t1) ;
la formation d'une deuxième cavité (K2) partant du côté arrière (RS) et s'étendant jusqu'à la première profondeur (t1) ;
la formation d'une zone d'abaissement (ST1 ; ST2) agencée entre la première cavité (K1a; K1b) et la deuxième cavité (K2), qui est abaissée par rapport au côté arrière (RS), en partant du côté arrière (RS), jusqu'à une deuxième profondeur (t2) ;
dans lequel la première profondeur (t1) est supérieure à la deuxième profondeur (t2) ;
la formation d'une ouverture de passage (V) en partant du côté avant (VS) par élimination d'une zone du substrat d'interposition (1) se trouvant au-dessus de la deuxième cavité (K2).

7. Procédé de fabrication selon la revendication 6, dans lequel la première cavité (K1a ; K1b) et la deuxième cavité (K2) sont formées simultanément lors d'une première étape de gravure en partant du côté arrière (RS) jusqu'à une profondeur intermédiaire (t0), et la zone du côté arrière (RS) correspondant à la zone d'abaissement (ST1 ; ST2) à former ultérieurement est masquée, et dans lequel la première cavité (K1a; K1b) et la deuxième cavité (K2) sont formées simultanément dans une deuxième étape de gravure en partant du côté arrière (RS) jusqu'à la première profondeur (t1), et la zone d'abaissement (ST1 ; ST2) est formée simultanément.

8. Procédé de fabrication selon la revendication 6 ou 7, dans lequel, après la formation de la première cavité (K1a ; K1b) et de la deuxième cavité (K2) et de la zone d'abaissement (ST1 ; ST2), une couche de protection (M4) est déposée sur le côté arrière (RS) avant la formation de l'ouverture de passage (V).
